Europäisches Patentamt

European Patent Office

Office européen des brevets

(11) Veröffentlichungsnummer: **0 200 239 B1**

# (12) EUROPÄISCHE PATENTSCHRIFT

(45) Veröffentlichungstag der Patentschrift: **03.03.93**

(21) Anmeldenummer: **86200438.9**

(22) Anmeldetag: **19.03.86**

(51) Int. Cl.⁵: **H03H 17/06**, H03H 17/02

(54) Digitale Polyphasen-Filterbank mit maximaler Taktreduktion.

(30) Priorität: **23.03.85 DE 3510573**

(43) Veröffentlichungstag der Anmeldung:
**10.12.86 Patentblatt 86/45**

(45) Bekanntmachung des Hinweises auf die
Patenterteilung:
**03.03.93 Patentblatt 93/09**

(84) Benannte Vertragsstaaten:
**AT BE CH DE FR GB IT LI NL SE**

(56) Entgegenhaltungen:
**EP-A- 0 065 210**
**EP-A- 0 070 948**

(73) Patentinhaber: **Philips Patentverwaltung GmbH**
**Wendenstrasse 35 Postfach 10 51 49**
**W-2000 Hamburg 1(DE)**

(84) Benannte Vertragsstaaten:
**DE**

(73) Patentinhaber: **N.V. Philips' Gloeilampenfabrieken**
**Groenewoudseweg 1**
**NL-5621 BA Eindhoven(NL)**

(84) Benannte Vertragsstaaten:
**BE CH FR GB IT LI NL SE AT**

(72) Erfinder: **Vary, Peter, Dr. Ing.**
**Fasanenweg 70**
**W-8522 Herzogenaurach(DE)**

(74) Vertreter: **Peuckert, Hermann, Dipl.-Ing. et al**
**Philips Patentverwaltung GmbH Wendenstrasse 35 Postfach 10 51 49**
**W-2000 Hamburg 1 (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine digitale Polyphasen-Filterbank gemäß dem Oberbegriff des Patentanspruchs 1.

Digitale Filterbänke können zur spektralen Aufspaltung eines diesen zugeführten Eingangssignals in Teilbandsignale, insbesondere bei der Übertragung, Speicherung und Verarbeitung von Signalen, eingesetzt werden. Je nach Anwendungsfall werden die so erzeugten Teilbandsignale codiert und/oder verarbeitet. Aufgrund der reduzierten Bandbreite der mittels der digitalen Filterbank erzeugten Teilbandsignale können die Teilbandsignale nach dem Abtasttheorem mit reduzierter Abtastfrequenz dargestellt werden. Dadurch kann sowohl der Rechenaufwand für die Analyse-Filterbank als auch der Aufwand für ie Übertragung, Speicherung und Verarbeitung der Teilbandsignale entsprechend reduziert werden.

Infolge der vorgenommenen Taktreduktion muß, zur Rekonstruktion bzw. Synthese eines Ausgangssignals aus den Teilbandsignalen, in einer Synthese-Filterbank die Abtastfrequenz erhöht werden. Durch Erhöhung der Abtastfrequenz auf das ursprüngliche Maß wird eine Interpolation der Teilbandsignale bewirkt und die so erzeugten interpolierten Teilbandsignale werden zum Ausgangssignals additiv einander überlagert.

Wie bereits ausgeführt ist es zur Reduzierung des hiermit verbundenen Aufwands, insbesondere bei der Übertragung und Speicherung von Signalen, notwendig eine maximale Taktreduktion vorzunehmen. Die maximale Taktreduktion ergibt sich nach dem Abtasttheorem aus der Bandbreite der Teilbandsignale. Unter der Voraussetzung einer digitalen Filterbank mit Kanälen der konstanten Bandbreite Fa/M, wobei mit Fa die Abtastfrequenz des Eingangssignals und mit M die Kanalzahl bezeichnet ist, kann die Abtastfrequenz bei reellen Bandfiltern um den Faktor $r = M/2$ oder, sofern ideale Bandfilter vorausgesetzt werden, bei komplexen Bandfiltern um den Faktor $r = M$ reduziert werden. Aufgrund der endlichen Flankensteilheit von realen Filtern kann die vorgenannten maximale Taktreduktion nicht vorgenommen werden.

Aus "Multirate digital signal processing" von Ronald E. Crochiere, Prentice-Hall, Inc., Englewood Cliffs, New Jersey 07632, insbesondere Seiten 376 bis 382, ist für den Sonderfall $M = 2$ und $r = 2$ eine als Quadratur-Spiegel-Filterung bezeichnete Lösung bekannt (QMF = Quadrature Mirror Filter), bei der die auftretenden spektralen Rückfaltungsanteile in der Synthese-Filterbank kompensiert werden. Durch Zusammenschaltung von insgesamt M-1 zweikanaligen Filterbänken zu einer Baumstruktur kann auch bei einer M-kanaligen Filterbank eine maximale Taktreduktion vorgenommen werden (vergleiche Seite 379).

Die so erzeugte M-kanalige Filterbank weist den Nachteil auf, daß einerseits ein relativ hoher Aufwand für die insgesamt 2•(M-1) Filter erforderlich ist, andererseits die Kaskadierung von jeweils 1d(M) Teilfiltern eine hohe Signalverzögerung bedingt.

Aus der EP-A-0070948 ist eine Filterbank bekannt, bei der zwei identische QMF-Filter eingesetzt werden. Jedes der QMF-Filter besteht aus einer Kaskadierung von Teilfiltern. An den Eingang des einen QMF-Filters wird das mit einer Cosinus-Funktion modulierte Eingangssignal und an den Eingang des anderen Filters das mit einer Sinus-Funktion modulierte Eingangssignal gelegt. Die Ausgangssignale des Analyseteils der Filterbank sind an den geringstmöglichen Takt gebunden, der ohne Informationsverlust zulässig ist. Die Filterbank arbeitet also mit maximaler Taktreduktion. Wegen der QMF-Filter gilt jedoch auch in diesem Falle, daß ein hoher Aufwand an Filtern erforderlich ist und das zusätzlich eine große Signalverzögerung in Kauf genommen werden muß.

Für Filterbänke mit einer Kanalzahl M>2, welche nicht mit maximaler Taktreduktion arbeiten, wird häufig die Polyphasen-Filterbank benutzt, welche im Vergleich zur vorgenannten Baumstruktur einen geringeren Schaltungsaufwand erfordert. Aus der DE-A-31 18 473 ist eine mehrkanalige Filterbank bekannt, welche durch die Kombination eines digitalen Polyphasen-Netzwerks mit einem Processor zur Diskreten Fourier-Transformation (DFT) entsteht. Diese Filterbank weist eine deutlich kürzere Signalverzögerung gegenüber der Filterbank mit Baumstruktur auf und auch der Schaltungsaufwand ist niedriger.

Für den Fall, daß eine maximale Taktreduktion vorgenommen wird, treten bei der vorgenannten Filterbank Rückfaltungsverzerrungen auf, welche in der Synthese-Filterbank nicht kompensiert werden.

Der Erfindung liegt die Aufgabe zugrunde, eine aus der DE-A-31 18 473 bekannte digitale Analyse-Synthese-Filterbank so auszugestalten, daß auch im Fall maximaler Taktreduktion die störenden Rückfaltungsverzerrungen kompensiert werden.

Diese Aufgabe wird durch eine digitale Analyse-Synthese-Filterbank gemäß dem Patentanspruch 1 gelöst.

Die erfindungsgemäße digitale Analyse-Synthese-Filterbank weist den Vorteil auf, daß durch die dabei angewandte modifizierte zweistufige Taktreduktion komplexe Polyphasen-Filterbänke mit maximaler Taktreduktion realisiert werden können. Die dabei auftretenden störenden Rückfaltungsanteile können auf einfache Art und Weise bei der Synthesefilterung kompensiert werden.

EP 0 200 239 B1

Die im Patentanspruch 2 angegebene Ausführungsform der Erfindung weist den Vorteil auf, daß Symmetrie-Eigenschaften der DFT ausgenutzt werden können. Mit einer einzigen DFT-Transformation kann gleichzeitig die cos- und sin-Transformation zweier unterschiedlicher Eingangsvektoren berechnet werden.

Die im Patentanspruch 3 angegebene Ausführungsform weist den Vorteil auf, daß die Transformationslänge sich auf M/2 verkürzt.

Die Erfindung wird im folgenden anhand in der Zeichnung dargestellter Ausführungsformen näher beschrieben und erläutert. Es zeigt:

Fig. 1     eine erste Ausführungsform und

Fig. 2     eine zweite Ausführungsform der erfindungsgemäßen digitalen Analyse-Synthese-Filterbank

Fig. 3     die in der ersten Ausführungsform nach Fig. 1 und

Fig. 4     die in zweiten Ausführungsform nach Fig. 2 auftretenden Teilbandsignale im Frequenzbereich.

Die erfindungsgemäße digitale Analyse-Synthese-Filterbank kann in vorteilhafter Weise in den Teilbandcodern eine digitalen Funkübertragungssystems eingesetzt werden.

Die Teilbandcodierung bekannter digitaler Funkübertragungssysteme basiert auf dem Prinzip der in Baumstruktur kaskadierten QMF-Filter (siehe "Multirate Digital Signal Processing" von Ronald E. Crochiere, Prentice-Hall). Der Vorteil dieses Verfahrens liegt -wie bereits ausgeführt-darin, daß die im Coder durch Unterabtastung entstehenden Rückfaltungsverzerrungen bei der Interpolationsfilterung im Decoder kompensiert werden.

Von Nachteil ist, daß -durch die Kaskadierung- die Laufzeit um ca. den Faktor 2 größer wird als aufgrund der Bandbreite erforderlich ist. Demgegenüber lassen sich mit sog. Polyphasen-Netzwerk-Filterbänken (PPN = Poly-Phase-Network), wie diese aus der DE-A-31 18 473 bekannt sind, die Mindestlaufzeiten realisieren.

Die für Halbband-Filter bekannte QMF-Methode der Quadratur-Spiegel-Bedingungläßt sich auf die PPN-Filterbank übertragen. Unter Einbeziehung der realiserungsbedingten Verzögerungen besitzt damit die erfindungsgemäße digitale Analyse-Synthese-Filterbank mit M = 8 Kanälen eine Verzögerung von nur 10 ms. Hinzuzurechnen ist die zur Codierung und Decodierung der Teilsbandsignale benötigte Rechenzeit. Bei Verdoppelung der Kanalzahl ist dieser Wert ebenfalls zu verdoppeln. In dieser Hinsicht besitzt der Teilbandcoder mit der erfingungsgemäßen digitalen Ana-Teilbandcoder mit der erfindungsgemäßen digitalen Analyse-Synthese-Filterbank einen deutlichen Vorteil gegenüber den verschiedenen RELP-Coder-Varianten.

Die adaptive Bitzuordnung auf die einzelnen Bänder erfolgt ähnlich dem aus der DE-A-31 18 473 bekannten Verfahren. Dabei wird das erste Bit dem Kanal mit maximaler Leistung zugeordnet. Anschließend wird die Leistung dieses Kanals durch 4 dividiert und das nächste Bit wird wieder dem Kanal zugesprochen, der dann die größte Leistung besitzt. Dieses Verfahren wird solange wiederholt, bis alle Bits vergeben sind. Die eigentliche Bitzuordnung muß dem Decoder nicht mitgeteilt werden, da diese aus der übertragenen Nebeninformation bestimmt werden kann. Insgesamt werden für Coder und Decoder zusammen vier Prozessoren (z.b. integrierter Signalprozessor NEC $\mu$ PD 7720) benötigt.

In Anbetracht der akustischen Randbedingungen für die Reduktion von Störungen werden zur Sprachcodierung nur solche Algorithmen eingesetzt, die weitgehend unempfindlich bei akustischen Hintergrundstörungen sind. Dies bedingt eine gewisse Transparenz bezüglich der Störungen, (d.h., daß Hintergrundstörungen mit übertragen werden). Es ist möglich, das gestörte Sprachsignal vor der Codierung durch adaptive Filterung zu verbessern. Ein Verfahren, das sich zur Reduktion bestimmter Störungen eignet ist aus der DE-A-31 18 473 bekannt. Es basiert auf einer Teilbandzerlegung des gestörten Signals und einer adaptiven Verarbeitung der Teilbandsignale. Mit diesem Verfahren lassen sich insbesondere periodische Störungen wirkungsvoll unterdrücken, während bei rauschartigen Störungen ein reduziertes Restgeräusch verbleibt. In vorteilhafter Weise wird die daraus bekannte digitale Filteranordnung mit einem Teilbandcoder kombiniert. Für beide Funktionen ist dann nur eine gemeinsame Filterbank erforderlich.

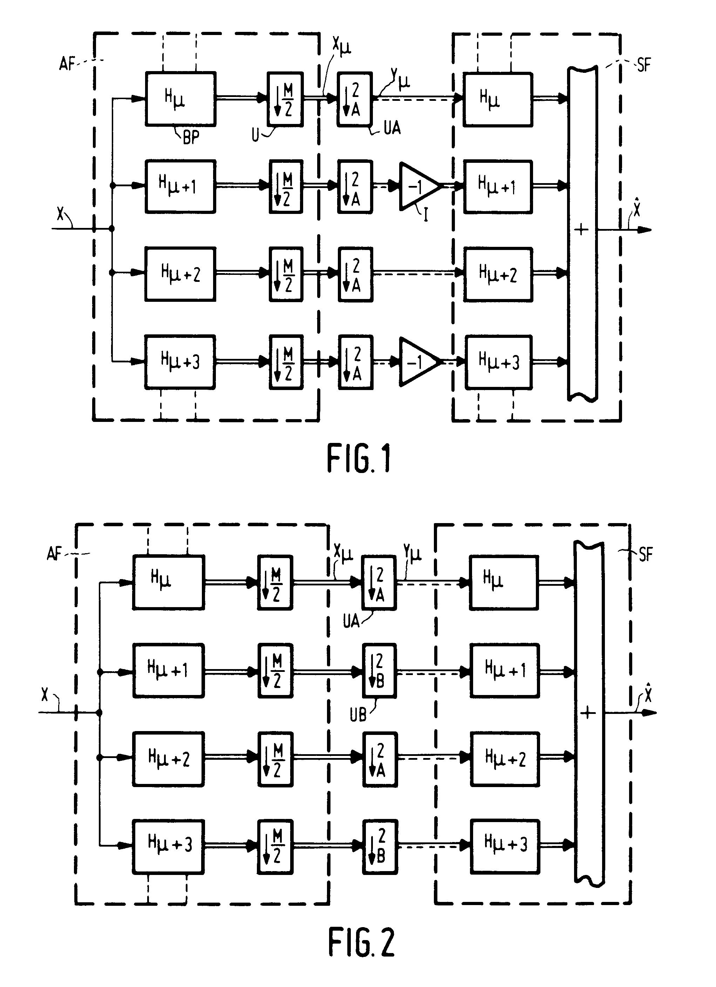

Die Anaylse-Filterbank AF spaltet das zugeführte Eingangssignal x mittels parallel angeordneter, komplexer Bandpässe BP in komplexe Teilbandsignale auf, welche in einer nachfolgenden Einrichtung U unterabgetastet werden. Hierfür wird, wie in Fig. 1 dargestellt, bevorzugt eine Polyphasen-Netzwerk-Filterbank AF (PPN-Filterbank) mit einer Taktreduktion um den Faktor r = M/2 verwendet. Diese erste Stufe der Taktreduktion ist in der DE-A-31 18 473 ausführlich beschrieben. Die M dabei auftretenden komplexen Teilbandsignale $x_\mu$ sind komplexwertig entsprechend der Gleichung

(1)     $x_\mu(i \cdot M/2) = a_\mu(i) + j \cdot b_\mu(i)$  $\mu = 0,1,..,M-1$

In der zweiten Stufe der Taktreduktion erfolgt mittels der Unterabtaster UA eine weitere Reduktion der Datenrate um den Faktor 2 gemäß der nachfolgenden Gleichung

3

$$(2) \quad y_\mu(i) = 0,5 \cdot (x_\mu(i) + (-1)^i \cdot x_\mu^*(i)) =$$

$$= \begin{cases} a_\mu(i); & i = \text{gerade} \\ \\ j_\mu \cdot b_\mu(i); & i = \text{ungerade} \end{cases}$$

wobei $x_\mu^*$ (i) die konjugiert komplexen Werte der Folge $x_\mu$ (i) bezeichnet. Erfindungsgemäß erfolgt die weitere Taktreduktion der M-komplexen Teilbandsignale $x_\mu$ durch versetztes Unterabtasten (komplexe Taktreduktion) der Real- und Imaginärteilsignale $a_\mu(i)$ und $b_\mu(i)$.

Da alternierend nur der Realteil oder der Imaginärteil benötigt wird, entspricht die Datenrate, für die Übertragung oder Speicherung und/oder Verarbeitung, der Datenrate bei maximaler Taktreduktion um den Faktor $r = M$.

Die zweite Stufe der Taktreduktion um den Faktor 2 kann bei der Realisierung der Analyse-Filterbank AF unmittelbar berücksichtigt werden, indem der DFT-Prozessor derartig ausgelegt wird, daß er nur die jeweils benötigten Werte $a_\mu(i)$ und $b_\mu(i)$ berechnet.

Wie in Fig. 1 dargestellt, wird am Eingang einer Synthese-Filterbank SF mittels einer Einrichtung I das Vorzeichen jedes zweiten Kanals invertiert, d.h. alle ungeradzahlig indizierten Kanäle. Zur Synthese wird auch eine PPN-Filterbank mit einer Interpolation um den Faktor $r = M/2$ verwendet. Auch hierbei wird in vorteilhafter Weise davon Gebrauch gemacht, daß zu jedem Zeitpunkt i die Teilbandsignale $y_\mu$ (i) entweder nur reelle oder nur imaginäre Werte annehmen.

Aus "A Unified Approach to Digital Polyphase Filter Banks" von Dr. P. Vary and G. Wackersreuther, (Abdruck in AEÜ, Band 37, (1983), Seiten 29 bis 34) sind die Beziehungen zwischen den Frequenzspektren der Eingangs- und Ausgangssignale bekannt. Unter Berücksichtigung der vorgenannten zweistufigen Taktreduktion kann gezeigt werden, daß für das Ausgangssignal $\hat{X}$ folgende Gleichung gilt:

$$(3) \quad \hat{X}(\Omega) = \sum_{\mu=0}^{M-1} (-1)^\mu \cdot \left[ H(\Omega - \frac{2\pi}{M} u) \right]^2 \cdot X(\Omega)$$

wobei $\Omega = 2\pi f/F_a$ und $H(\Omega)$ die Übertragungsfunktion des Prototyp-Tiefpasses der Filterbank ist.

Bedingung hierfür ist, daß die Sperrgrenze des Prototyp-Tiefpasses der Filterbank, die in der nachfolgenden Gleichung angegebenen Bedingung erfüllt:

$$(4) \quad |H(\Omega)| < \delta \text{ für } \frac{2\pi}{M} \leq \Omega \leq \pi$$

und die Sperrdämpfung 20 log ($\delta$) genügend hoch ist. In diesem Zusammenhang bedeutet genügend hoch, daß die mit der Sperrdämpfung beaufschlagten Signalanteile vernachlässigt werden können. In der Praxis ist diese Bedingung erfüllt, wobei nach Gleichung (4) eine 50 %ige spektrale Überlappung benachbarter Filterbankkanäle zulässig ist. Die bei der maximalen Taktreduktion auftretenden störenden Rückfaltungsverzerrungen, die jeweils zwischen benachbarten Kanälen auftreten, werden bei der Synthese-Filterung kompensiert.

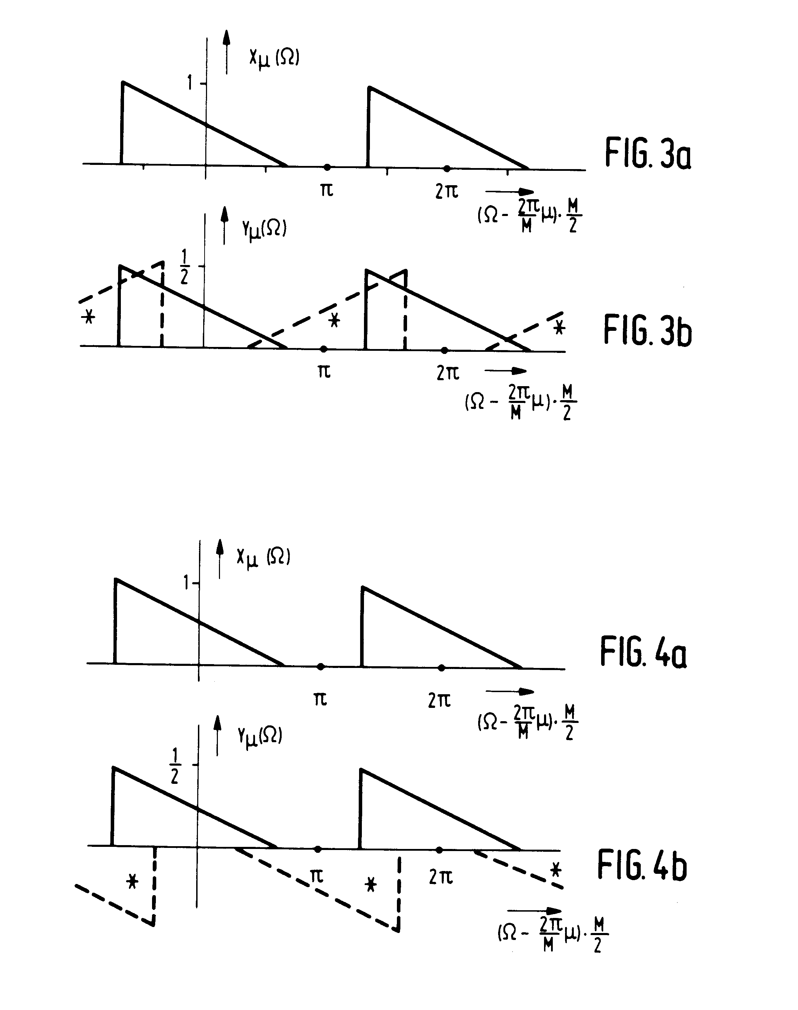

Anhand der in Fig. 3 dargestellten Teilbandsignale wird die zweite Stufe der erfindungsgemäßen Taktreduktion näher beschrieben und erläutert. Das in Fig. 3a dargestellte komplexe Teilbandsignal $x_\mu(i)$ wird bei einer Unterabtastung gemäß der Gleichung (2) in das in Fig. 2b dargestellte Spektrum übergeführt. Dem konjugiert komplexen Zeitsignal $x_\mu^*$ (i) entspricht das gespiegelte, konjugiert komplexe Freqeunzspektrum, das durch Modulation mit $(-1)^\mu$ (siehe Gleichung (2)) spektral um die normierte Frequenz $\pi$ verschoben wird. Aufgrund der Spiegelung und Verschiebung kann durch alternierende Vorzeichenumkehr bei jedem zweiten Teilbandsignal eine Kompensation der störenden Rückfaltungsanteile bei der Synthese-Filterung vorgenommen werden. Indem durch die Spiegelung eine Wechselwirkung zwischen benachbarten Filtern der Analyse- und Synthese-Filterbank AF und SF entsteht, wird zwischen zwei benachbarten Kanälen ein Kompensationsmechanismus wirksam.

In Fig. 2 ist eine weitere Ausführungsform der erfindungsgemäßen digitalen Analyse-Sythese-Filterbank dargestellt. Für die Analyse-Filterbank AF wird ebenfalls (wie in Fig. 1) die PPN-Filterbank mit einer Taktreduktion um den Faktor $r = M/2$ verwendet. Somit wird, wie bei der ersten Ausführungsform, für die erste Stufe der Taktreduktion die aus der DE-A-31 18 473 bekannte Analyse-Filterbank benutzt. Für die

EP 0 200 239 B1

weitere Taktreduktion in der zweiten Stufe werden die Teilbandsignale $x_\mu$ benachbarter Kanäle komplementär um den Faktor 2 unterabgetastet, entsprechend der nachfolgenden Gleichung:

$$(5a) \quad y_\mu(i) = \begin{cases} a_\mu(i) & ; \; i = \text{gerade und } \mu = 0,2,4.. \\ \\ j \cdot b_\mu(i) & ; \; i = \text{ungerade und } \mu = 0,2,4.. \end{cases}$$

Um in Fig. 2 die Berechnung der Teilbandsignale $y_\mu$ (i) gemäß der Gleichung (5a) zu verdeutlichen, ist der Unterabtaster mit einer Buchstaben A bezeichnet (Entsprechend für die Gleichung (5b) mit UB bezeichnet).

Weiterhin wird die zur Unterabtastung gemäß der Gleichung (5a) komplementäre Unterabtastung der Teilbandsignale gemäß der Gleichung:

$$(5b) \quad y_u(i) = 0,5 \cdot (x_\mu(i) - (-1)^i \cdot x_\mu^*(i)) = \\ = \begin{cases} j \cdot b_\mu(i); \; i \text{ gerade} \\ \quad \text{und } \mu = 1, \, 3, \, 5... \\ a_\mu(i); \; i \text{ ungerade} \end{cases}$$

vorgenommen. Die unterschiedliche Behandlung der ungeradezahlig oder geradzahlig indizierten Kanäle (Teilbandsignale) kann auch vertauscht werden.

Im Vergleich zur Ausführungsform gemäß Fig. 1 ist vor der Synthese keine alternierende Vorzeichenumkehr benachbarter Teilbandsignale erforderlich. Unter den vorgenannten Voraussetzungen an den Prototype-Tiefpaß gilt in diesem Fall die Eingangs-Ausgangs-Beziehung der nachfolgenden Gleichung

$$(6) \quad X(\Omega) = \sum_{\mu = 0}^{M-1} \left[ H(\Omega - \frac{2\pi}{M} \mu) \right]^2 \cdot X(\Omega)$$

Zur Berechnung von Prototyp-Tiefpässen, die bei Überlagerung des Frequenzganges nach den Gleichungen (3) oder (6) einen konstanten Summenfrequenzgang der Analyse-SyntheseFilterbank liefern sind geeignete Verfahren aus der Literatur bekannt. ("Digital Signal Processing" von A.V. Oppenheim, Prentice Hall, 1975)

Die in Gleichung (5b) angegebene Unterabtastung, welche zu den komplexen Teilbandsignalen $y_\mu(i)$ führt, ist in Fig. 4 dargestellt. Wie ein Vergleich der Fig. 4b mit Fig. 2b zeigt, besitzt die durch die Unterabtastung entstehende gespiegelte Wiederholung des Spektrums ein negatives Vorzeichen (siehe auch Gleichung (5b) und Gleichung (2)).

Aufgrund dieser Vorzeichenumkehr kann die alternierende Vorzeichenumkehr der Teilbandsignale $y_\mu(i)$ entfallen, wobei der wirksame Summenfrequenzgang nach Gleichung (6) entsteht.

## Patentansprüche

1. Digitale Polyphasen-Filterbank, bei der in einer Analyse-Filterbank (AF) ein Eingangssignal (x) in M komplexe Teilbandsignale ($x_\mu$) mit gleichzeitiger Taktreduktion (um dem Faktor M/2) aufgespalten wird und bei der die M komplexen Teilbandsignale ($x_\mu$) nach einer Verarbeitung einer Synthese-Filterbank (SF) zugeführt werden, welche durch Interpolation die Abtastfrequenz wieder erhöht und durch Addition der interpolierten Teilbandsignale ($y_\mu$) ein Ausgangssignal (X) erzeugt,
   dadurch gekennzeichnet,
   daß bei der Verarbeitung eine weitere Taktreduktion der M komplexen Teilbandsignale ($x_\mu$) durch versetztes Unterabtasten (komplexe Taktreduktion) der Real- und Imaginärteilsignale ($a_\mu(i)$, $b_\mu(i)$) erfolgt.

5

**2.** Filterbank nach Anspruch 1,
dadurch gekennzeichnet,
daß die komplexe Taktreduktion aller M komplexen Teilbandsignale ($x_\mu$) gemäß Gleichung (2) erfolgt und daß das Vorzeichen jedes zweiten, komplexen Teilbandsignals ($y_\mu$) invertiert wird.

**3.** Filterbank nach Anspruch 1, dadurch gekennzeichnet, daß die komplexe Taktreduktion der geradzahlig indizierten M komplexen Teilbandsignale ($x_\mu$) gemäß der Gleichung (2) und die komplexe Taktreduktion der ungeradzahlig indizierten M komplexen Teilbandsignale ($x_\mu$) gemäß der Gleichung (5b) erfolgt.

**Claims**

**1.** Digital polyphase filter bank, in which in an analysing filter bank (AF) an input signal (x) is split up into M complex sub-band signals ($x_\mu$) with simultaneous sampling rate reduction (by a factor of M/2) and in which the M complex sub-band signals ($x_\mu$) after having been processed are applied to a synthesizing filter bank (SF), which by interpolation increases the sampling rate again and by adding together the interpolated sub-band signals ($y_\mu$) produces an output signal (X), characterized in that in the processing operation a further sampling rate reduction of the M complex sub-band signals ($x_\mu$) is effected by staggered sampling rate reduction (complex sampling rate reduction) of the real and imaginary components ($a_\mu(i)$, $b_\mu(i)$) of said complex sub-band signals ($x_\mu$).

**2.** Filter bank as claimed in Claim 1, characterized in that the complex sampling rate reduction of all the M complex sub-band signals ($x_\mu$) is effected in accordance with equation (2) and in that the sign of every second complex sub-band signal $y_\mu$ thus obtained is inverted.

**3.** Filter bank as claimed in Claim 1, characterized in that the complex sampling rate reduction of the M complex sub-band signals ($x_\mu$) having even index numbers is effected in accordance with equation (2) and the complex sampling rate reduction of the M complex sub-band signals ($x_\mu$) having odd index numbers is effected in accordance with equation (5b).

**Revendications**

**1.** Banc de filtres polyphasés numériques, dans lequel, dans un banc de filtres d'analyse (AF), un signal d'entrée (x) est divisé en M signaux de bande partielle ($x_\mu$) complexes avec une réduction de cadence (du facteur M/2) simultanée et dans lequel les M signaux de bande partielle complexes ($x_\mu$) sont appliqués, après un traitement, à un banc de filtres de synthèse (SF) qui augmente à nouveau la fréquence d'échantillonnage par interpolation et produit, par addition des signaux de bande partielle interpolés ($y_\mu$), un signal de sortie (X), caractérisé en ce que, lors du traitement, une nouvelle réduction de cadence des M signaux de bande partielle complexes ($x_\mu$) est réalisée par sous-échantillonnage décalé (réduction de cadence complexe des signaux partiels réels et imaginaires ($a_\mu(i)$, $b_\mu(i)$).

**2.** Banc de filtres suivant la revendication 1, caractérisé en ce que la réduction de cadence complexe de l'ensemble des M signaux de bande partielle complexes ($x_\mu$) est réalisée selon l'équation (2) et que le signe de chaque second signal de bande partielle complexe ($y_\mu$) est inversé.

**3.** Banc de filtres suivant la revendication 1, caractérisé en ce que la réduction de cadence complexe des M signaux de bande partielle complexes ($x_\mu$) à indice pair est réalisée selon l'équation (2) et la réduction de cadence complexe des M signaux de bande partielle complexes à indice impair ($x_\mu$), selon l'équation (5b).

FIG.1

FIG.2

7

$X_\mu(\Omega)$

FIG. 3a

$\left(\Omega - \dfrac{2\pi}{M}\mu\right) \cdot \dfrac{M}{2}$

$Y_\mu(\Omega)$

FIG. 3b

$\left(\Omega - \dfrac{2\pi}{M}\mu\right) \cdot \dfrac{M}{2}$

$X_\mu(\Omega)$

FIG. 4a

$\left(\Omega - \dfrac{2\pi}{M}\mu\right) \cdot \dfrac{M}{2}$

$Y_\mu(\Omega)$

FIG. 4b

$\left(\Omega - \dfrac{2\pi}{M}\mu\right) \cdot \dfrac{M}{2}$